# EUROPEAN PATENT SPECIFICATION

(11) **EP 4 576 399 B1**
(45) Date of publication and mention of the grant of the patent: **18.11.2026**
(21) Application number: 24215065.4
(22) Date of filing: 25.11.2024
(51) Int. Cl.: H01M 50/507, H01M 50/51, G01R 31/36, G01R 31/389, G01R 31/392, H01M 10/48, H01M 50/258, H01M 50/325, H01M 50/342, H01M 50/503, H01M 50/519

(54) **BATTERY MODULE AND BATTERY MODULE COLLECTION MECHANISM**
BATTERIEMODUL UND BATTERIEMODULSAMMELMECHANISMUS
MODULE DE BATTERIE ET MÉCANISME DE COLLECTE DE MODULE DE BATTERIE

(30) Priority: 18.12.2023 CN 202323464404 U; 30.04.2024 WO PCT/CN2024/091043
(43) Date of publication of application: 25.06.2025
(73) Proprietor: Eve Energy Co., Ltd., Huizhou, Guangdong 516006 (CN)
(72) Inventor: LI, Caiyu, Huizhou, Guangdong 516006 (CN)
(74) Representative: Berggren Oy

(56) References cited:
- DE-A1- 102019 134 469
- US-A1- 2020 365 866
- US-A1- 2023 055 887

## Description

### TECHNICAL FIELD

The present disclosure relates to the field of battery technologies, and more particular to a battery module and a battery module collection mechanism.

### BACKGROUND

In the related art, a plurality of battery modules of a battery system may be connected in series with each other by an aluminum bar, and Cells Contact System (CCS) assemblies of the plurality of battery modules may be connected to a Battery Management System (BMS) through a plurality of transfer harnesses. As such, the harnesses of the integrated battery modules may be complicated, and Cell Supervision Circuits (CSC) assemblies of the plurality of battery modules may occupy installation positions between the battery modules, thereby reducing energy density.

US 2020/365866 A1 relates to a battery connection module, comprising: a carrying tray; a plurality of busbars provided to the carrying tray; and a flexible circuit board provided to the carrying tray and comprising a main board body and a plurality of connecting board bodies integrally connected to the main board body in a floatable manner and respectively electrically connected to the plurality of busbars, each connecting board body being provided to a side edge of the main board body, extending in a longitudinal direction and facing the corresponding busbar in a transverse direction, each connecting board body having a central portion and two cantilevered portions respectively extending from two opposite sides of the central portion in the longitudinal direction, each cantilevered portion having a proximal segment connected to the central portion, a distal segment and a curved segment positioned between the proximal segment and the distal segment, the curved segment extending along at least the longitudinal direction and the transverse direction, each connecting board body being connected to the main board body only by the distal segments of the two cantilevered portions, a gap being formed between the connecting board body and the main board body.

### SUMMARY

The present disclosure provides a battery module and a battery module collection mechanism, which can improve the low energy density.

In a first aspect, embodiments of the present disclosure provide a battery module collection mechanism, including: a bracket; and a collection group including a serial assembly; where the serial assembly includes a first serial group, a second serial group, and a first connection member all installed in the bracket, the first serial group and the second serial group each include a first serial row and a second serial row arranged oppositely, and the first serial group and the second serial group each is connected in series with a cell group, two first serial rows or two second serial rows of the first serial group and the second serial group are connected to each other by the first connection member.

In a second aspect, embodiments of the present disclosure provide a battery module, including: two collection groups, one or more battery grouping assemblies, and the above-described battery module collection mechanism provided in a number corresponding to a number of the battery grouping assemblies, where each of the battery grouping assemblies includes four cell groups, and each of the collection groups corresponds to two of the cell groups.

### Beneficial Effects

The beneficial effects of the present disclosure are as follows: the present disclosure provides a battery module collection mechanism which integrates the cell group corresponding to the first serial group with the cell group corresponding to the second serial group by providing the first serial group and the second serial group on the same bracket and connecting the cell group corresponding of the first serial group to the cell group corresponding of the second serial group with the first connection member, thereby facilitating the two cell groups to share a cell signal collection device, further reducing the CSC assembly connected to the cell signal collection device, saving a portion of space originally used for installing the CSC assembly so as to install more cells, and improving the energy density to solve the low energy density in the related art.

The present disclosure provides a battery module, including: two collection groups, one or more battery grouping assemblies, and the above-described battery module collection mechanism provided in a number corresponding to a number of the battery grouping assemblies. The battery module collection mechanism enables the cell groups to share a cell signal collection device, reduces the CSC assembly connected to the cell signal collection device to install more cells, and improves the energy density to solve the low energy density in the related art.

### DESCRIPTION OF THE DRAWINGS

FIG. 1 is a schematic structural diagram of a battery module according to some embodiments of the present disclosure.
FIG. 2 is an enlarged view of a portion A in FIG. 1.
FIG. 3 is a perspective diagram of a collection assembly according to some embodiments of the present disclosure.
FIG. 4 is an enlarged view of a portion B in FIG. 3.
FIG. 5 is a perspective diagram of a first connection member according to some embodiments of the present disclosure.
FIG. 6 is a perspective diagram of a bracket according to some embodiments of the present disclosure.
FIG. 7 is a schematic structural diagram of one side of two battery module collection mechanisms toward cells according to some embodiments of the present disclosure.
FIG. 8 is an enlarged view of a portion C in FIG. 7.
FIG. 9 is a schematic structural diagram of a first positioning member according to some embodiments of the present disclosure.
FIG. 10 is a schematic structural diagram of a battery module collection mechanism according to some embodiments of the present disclosure.
FIG. 11 is a schematic structural diagram of a battery module according to some embodiments of the present disclosure.

### REFERENCE NUMERALS OF THE ACCOMPANYING DRAWING:

1. Battery module collection mechanism; 100. Collection group; 110. Serial assembly; 120. Collection assembly; 11. First serial group; 12. Second serial group; 101. First serial row; 102. Second serial row; 13. First collection line; 131. First connection portion; 132. First buffer portion; 133. First groove; 14. Second collection line; 141. Second connection portion; 142. Second buffer portion; 143. Second groove; 21. First connection member; 211. First protrusion; 212. First recess; 22. First integrated member; 23. Second integrated member; 3. Bracket; 31. Collection line installing groove; 32. Connection member installing groove; 33. Explosion-proof hole; 4. Connection circuit board; 5. First positioning member; 51. First positioning groove; 6. Second positioning member; 61. Second positioning groove; 7. Cell grouping assembly; 71. Cell group.

### DETAILED DESCRIPTION

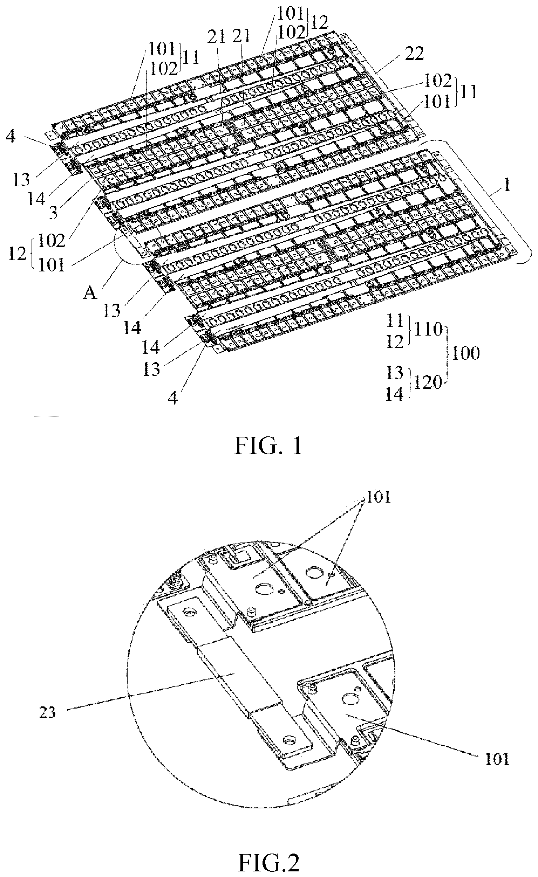

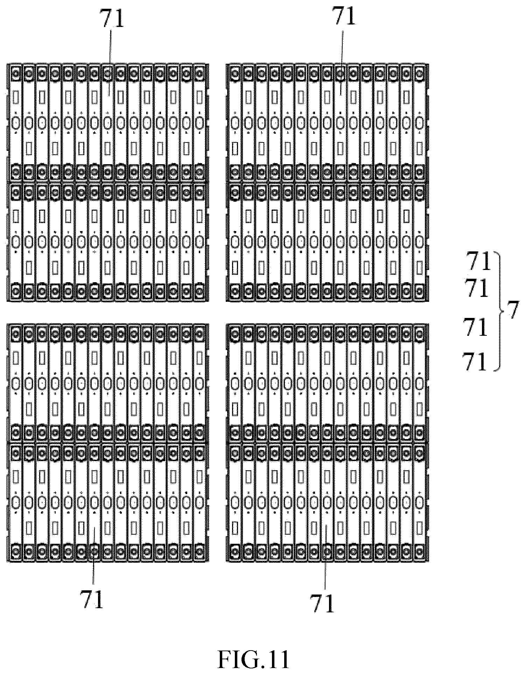

Referring to FIGS. 1 and 11, a battery module collection mechanism 1 provided in the embodiments of the present disclosure may include: a bracket 3; and a collection group 100 including a serial assembly 110; where the serial assembly 110 includes a first serial group 11, a second serial group 12, and a first connection member 21 all installed on the bracket 3, the first serial group 11 and the second serial group 12 each includes a first serial row 101 and a second serial row 102 arranged oppositely, and the first serial group 11 and the second serial group 12 each is connected in series with a cell group 71, two first serial rows 101 or two second serial rows 102 of the first serial group 11 and the second serial group 12 are connected to each other by the first connection member 21.

The first serial row 101 and the second serial row 102 may be provided on the same bracket 3, so that the cell groups 71 corresponding to the first serial row 101 and the second serial row 102 can be installed more closely, thereby improving the space utilization rate. Additionally, integration of the cell group 71 corresponding to the first serial row 101 with the cell group 71 corresponding to the second serial row 102 may be realized by connecting the first serial row 101 with the second serial row 102 through the first connection member 21, so that the two cell groups 71 can share a cell signal collection device, thereby reducing the CSC assembly connected to the cell signal collection device, saving a portion of the space originally used for installing the CSC assembly so as to install more cells, and improving the energy density.

Referring to FIGS. 1 and 11, a battery module collection mechanism 1 provided in the embodiments of the present disclosure may include: a bracket 3; and a collection group 100. The collection group 100 may include a serial assembly 110 and a collection assembly 120.

The serial assembly 110 may include a first serial group 11, a second serial group 12, and a first connection member 21 all installed on the bracket 3.

The collection assembly 120 may include a first collection line 13 and a second acquisition line 14 that both are installed on the bracket 3 and arranged oppositely.

The first serial group 11 may be configured to be connected in series with one cell group 71, and the second serial group 12 may be configured to be connected in series with another cell group 71. The first serial group 11 and the second serial group 12 may each include a first serial row 101 and a second serial row 102 arranged oppositely. The first serial row 101 and the second serial row 102 may be provided in the same number, the first serial row 101 and the second serial row 102 may be both configured to connect positive and negative electrodes of adjacent cells, and the first serial row 101 and the second serial row 102 arranged oppositely may be configured to connect the positive and negative electrodes of the same cell. The first connection member 21 may be disposed between the first serial group 11 and the second serial group 12 and configured to connect two first serial rows 101 or two second serial rows 102 of the first serial group 11 and the second serial group 12 in series, and further connects cell groups 71 corresponding to the first serial group 11 and the second serial group 12 in series, thereby realizing integration of the cell group 71 corresponding to the first serial group 11 with the cell group 71 corresponding to the second serial group 12.

The bracket 3 may be provided with a plurality of explosion-proof holes 33 for exposing cell explosion-proof valves, where the plurality of explosion-proof holes 33 are respectively provided between the first serial row 101 and the second serial row 102 to ensure smooth operation of the cell explosion-proof valves.

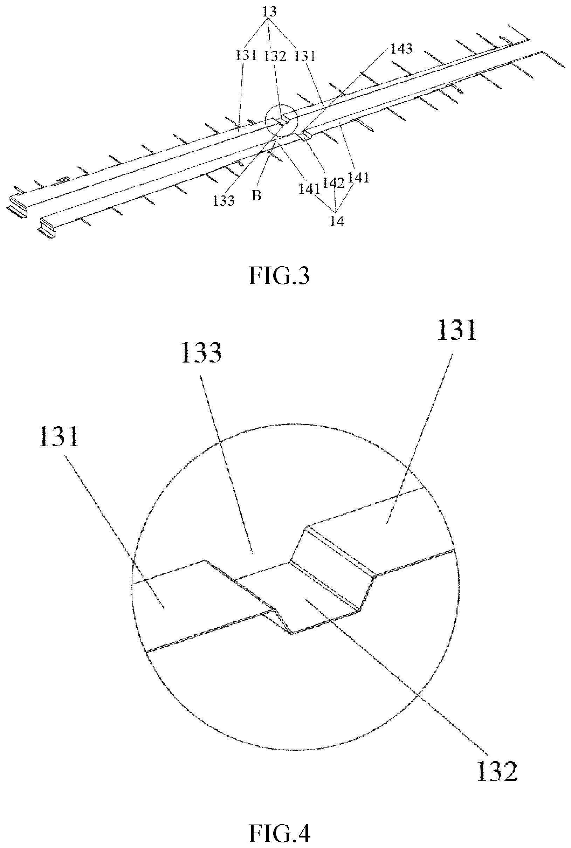

Referring to FIGS. 1 and 3, the first collection line 13 and the second collection line 14 may be positioned between the first serial row 101 and the second serial row 102, the first collection line 13 may be electrically connected to the two first serial rows 101 of the first serial group 11 and the second serial group 12, and the second collection line 14 may be electrically connected to the two second serial rows 102 of the first serial group 11 and the second serial group 12. The first collection line 13 and the second collection line 14 may be configured to collect voltage and temperature signals and the like of the cell groups 71.

The serial assembly 110 may further include two connection circuit boards 4 respectively connected to the first collection line 13 and the second collection line 14, where the two connection circuit boards 4 may be provided at one ends of the first collection line 13 and the second collection line 14, respectively, so as to facilitate connection with connectors of the CSC assembly.

Referring to FIGS. 3 and 4, the first collection line 13 may include two first connection portions 131 and a first buffer portion 132 connected between the two first connection portions 131. The two first connection portions 131 may be connected to the two first serial rows 101 of the first serial group 11 and the second serial group 12, respectively, and the first buffer portion 132 may be provided with a first groove 133 facing the bracket 3. In an extension direction of the first collection line 13, a distance between the first groove 133 and the first serial row 101 of the first serial group 11 may be equal to a distance between the first groove 133 and the first serial row 101 of the second serial group 12.

The second collection line 14 may include two second connection portions 141 and a second buffer portion 142 connected between the two second connection portions 141, the two second connection portions 141 may be connected to the two second serial rows 102 of the first serial group 11 and the second serial group 12, respectively, and the second buffer portion 142 may be provided with a second groove 143 facing the bracket 3. In an extension direction of the second collection line 14, a distance between the second groove 143 and the second serial row 102 of the first serial group 11 may be equal to a distance between the second groove 143 and the second serial row 102 of the second serial group 12. As such, the first groove 133 and the second groove 143 both may be positioned between the first serial row 101 and the second serial row 102. When a cell of a battery module emits heat and is expanded, a tension force to which the two first connection portions 131 and the two second connection portions 141 are subjected from the cell is made as equal as possible, thereby enabling the first buffer portion 132 and the second buffer portion 142 to be stretched to a large extent to better adapt to expansion of the cell.

A virtual connection line between the center of the first groove 133 and the center of the second groove 143 may be perpendicular to the extension direction of the first collection line 13, so that extension directions of the first buffer portion 132 and the second buffer portion 142 are the same as each other.

A cell expansion amount may be calculated by model simulation. For example, when the cell expansion amount is 1.5 mm, the lengths of the first buffer portion 132 and the second buffer portion 142 are twice the cell expansion amount, that is, 3.0 mm.

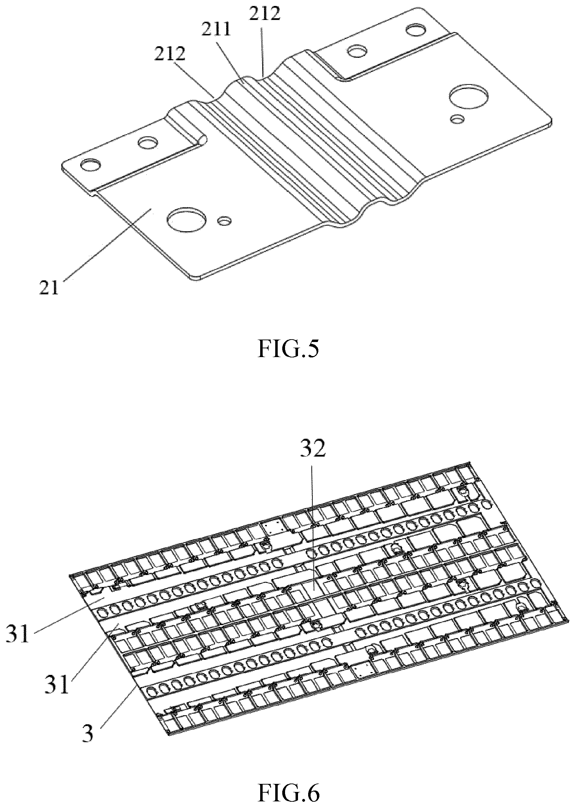

Referring to FIGS. 1 and 5, the first connection member 21 may be provided with a first protrusion 211 away from the bracket 3 and two first recesses 212 on both sides of the first protrusion 211, where the two first recesses 212 are recessed toward the bracket 3.

As such, the first connection member 21 may have a W-shaped-like structure. When the cell emits heat and is expanded, the first connection member 21 can be expanded to accommodate the cell expansion amount. Additionally, compared with a solution in which the first connection member 21 is provided with one first recess 212, the first protrusion 211 may be provided between the two first recesses 212, which can improve a structural strength of the first connection member 21, and prevent the first connection member 21 from being broken away as much as possible without plastic deformation.

The first protrusion 211 may extend in an extension direction perpendicular to the first collection line 13.

Widths and depths of the first protrusion 211 and the first recess 212 may be determined according to actual cell expansion amount and a tensile force test. In the present embodiment, the size of the first connection member 21 is 114.4 mm*61 mm*1.2 mm, and the depth of the first recess 212 is equal to the height of the first protrusion 211, which both are 3.5 mm. In the present embodiment, the serial assembly 110 may be made of aluminum, and the bracket 3 may be made of plastic.

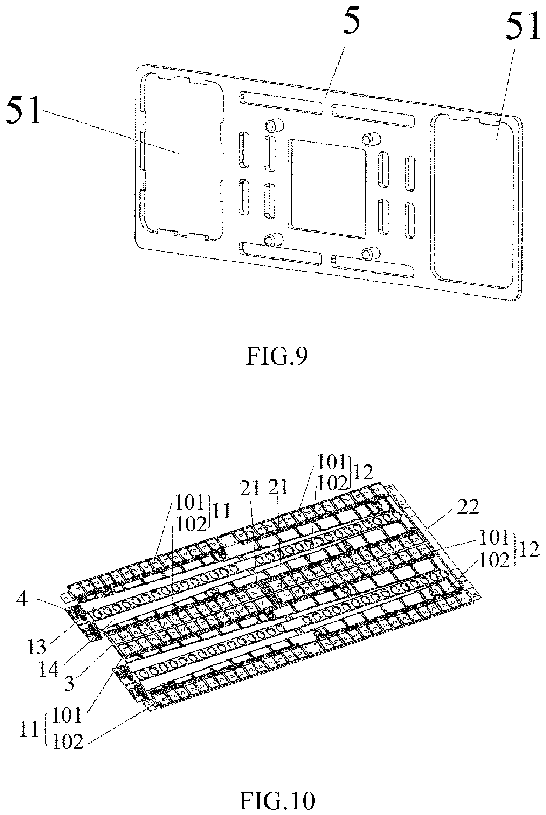

Referring to FIGS. 1, 10, and 11, an embodiment of the present disclosure may further provide a battery module, including: the battery module collection mechanism 1 described in any one of the above embodiments, a cell grouping assembly 7, and an integrated connection assembly.

The battery module collection mechanism 1 may be provided in two, where the two battery module collection mechanisms 1 correspond to two cell grouping assemblies 7, respectively. The cell grouping assembly 7 may include four cell groups 71, and the collection group 100 may be provided in two, where one of the two collection groups 100 corresponds to two of the four cell groups 71. The two cell groups 71 may be electrically connected to the first serial group 11 and the second serial group 12, respectively, and
the integrated connection assembly may include a first integrated member 22 and a second integrated member 23.

When the first connection member 21 may be connected to the two first serial rows 101 of the first serial group 11 and the second serial group 12, the first integrated member 22 may be connected to the two second serial rows 102 of the two collection groups 100, the two second serial rows 102 of the two first serial groups 11 of the two battery module collection mechanisms 1 may be connected to each other through the second integrated member 23, and the second integrated member 23 may be provided on one side of the first serial row 101 away from the first integrated member 22.

Alternatively, when the first connection member 21 may be connected to the two second serial rows 102 of the first serial group 11 and the second serial group 12, the first integrated member 22 may be connected to the two first serial rows 101 of the two collection groups 100, the two first serial rows 102 of the two first serial groups 11 of the two battery module collection mechanisms 1 may be connected to each other through the second integrated member 23, and the second integrated member 23 may be provided on one side of the first serial row 101 away from the first integrated member 22. The second integrated member 23 may be sleeved with an insulating sleeve for insulating the second integrated member 23 from a case beam of the battery module, which can protect the battery from being short-circuited when a safe distance between the second integrated member 23 and the case beam of the battery module is smaller.

In the present embodiment, the first connection member 21 may be connected to the two second serial rows 102 of the first serial group 11 and the second serial group 12. In this case, a flow path of a current of the battery module may be as follows: in one of the collection groups 100, the current flows through the cell group 71 corresponding to the first serial group 11 via the first serial group 11 and the second serial group 12 having the first serial rows 101 connecting adjacent cells in series, and the current flows into a second serial row 102 of the second serial group 12 through the first connection member 21and flows through the cell group 71 corresponding to the second serial group 12; then the current flows into a first serial row 101 of a first serial group 11 in another of the collection groups 100 via the first integrated member 22, and flows through the cell group 71 corresponding to the first serial group 11, the current flows into a second serial row 102 of a second serial group 12 through the first connection member 21 and flows through the cell group 71 corresponding to the second serial group 12; and finally, the current flows into a first serial row 101 of a first serial group 11 of another battery module collection mechanism 1 through the second integrated member 23.

Virtual extension lines of two first protrusions of two first connectors 21 of the two collection groups 100 may coincide with each other, so that the two first connectors 21 of the battery module collection mechanism 1 may be uniformly stressed, thereby facilitating better adaptation to the expansion of the cell.

In other embodiments, two first connectors 21 of two collection groups 100 may connect two first serial rows 101 or two second serial rows 102, respectively.

Integration of the four cell groups 71 may be achieved by the first connection member 21 and the first integrated member 22, and the four battery modules may be integrated into one larger battery module, thereby increasing the energy density. By extending the collection line on the original basis, the number of CSC assemblies may be reduced, thereby reducing the intermediate transfer harness.

In other embodiments, the battery grouping assembly 7 may also be provided in three, four or even more, the battery module collection mechanism 1 may be provided in a number corresponding to the number of the battery grouping assemblies 7, and the collection group 100 may also be provided in three, four or even more. Cell grouping groups 7 corresponding to different battery module collection mechanisms 1 may be electrically connected through the second integrated member 23, and the different collection groups 100 may be electrically connected through the first integrated member 22.

Referring to FIG. 6, the bracket 3 may be provided with four collection line installing grooves 31 for installing collection groups 100 and two connection member installing grooves 32 for installing the first connection member 21 and the second connection member, and the collection line installing grooves 31 and the connection member installing grooves 32 may be designed according to shapes of the collection groups and the connection member.

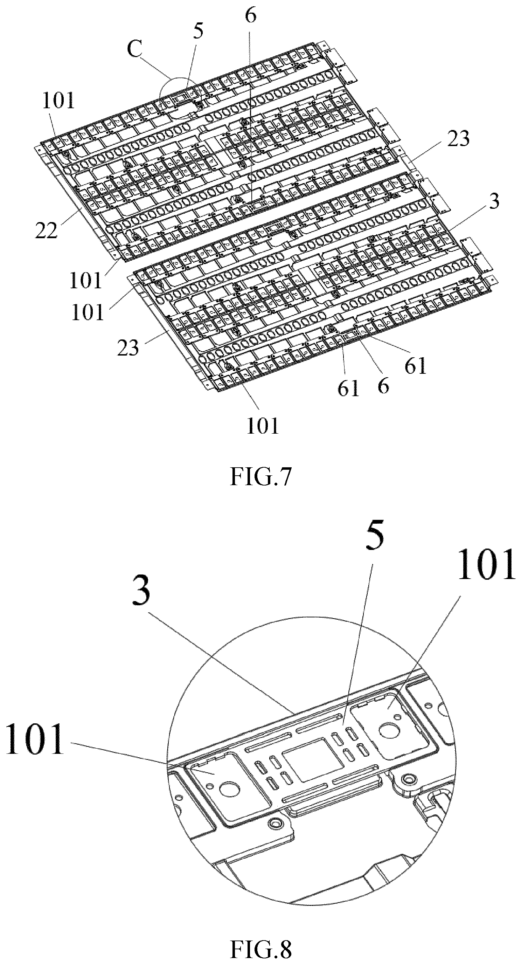

Referring to FIG. 7, the battery module may further include a positioning member including a first positioning member 5 and a second positioning member 6 arranged oppositely, where the first positioning member 5 and the second positioning member 6 are heat-riveted to the bracket 3 and each disposed on one side of the bracket 3 toward the cell group 71. The first positioning member 5 may be positioned between the two first serial rows 101 of the first serial group 11 and the second serial group 12 of one collection group 100, and the second positioning member 6 may be positioned between the two first serial rows 101 of the first serial group 11 and the second serial group 12 of another collection group 100.

Referring to FIGS. 7, 8 and 9, the first positioning member 5 may be provided with two first positioning grooves 51, that is, positioning grooves of the positioning members, where the two first positioning grooves 51 respectively expose a portion of the two first serial rows 101. The first positioning grooves 51 may be configured to embed poles of the cell into the first positioning grooves 51, and serve as positioning functions when the cell is welded to the first serial row 101.

The second positioning member 6 may be provided with two second positioning grooves 61, that is, positioning grooves of the positioning members, where the two second positioning grooves 61 respectively expose a portion of the two first serial rows 101 of the first serial group 11 and the second serial group 12 of another collection group 100. The second positioning grooves 61 may be configured to embed poles of the cell into the second positioning grooves 61, and serve as positioning functions when the cell is welded to the two first serial rows 101 of the first serial group 11 and the second serial group 12 of another collection group 100.

## Claims

1. A battery module collection mechanism (1), **characterized in that** the battery module collection mechanism (1) comprises:
a bracket (3); and
a collection group (100) comprising a serial assembly (110);
wherein the serial assembly (110) comprises a first serial group (11), a second serial group (12), and a first connection member (21) all disposed on the bracket (3), the first serial group (11) and the second serial group (12) each comprises a first serial row (101) and a second serial row (102) arranged oppositely, and the first serial group (11) and the second serial group (12) each is connected in series with a cell group, and two first serial rows (101) or two second serial rows (102) of both the first serial group (11) and the second serial group (12) are connected to each other by the first connection member (21).

2. The battery module collection mechanism (1) of claim 1, **characterized in that** the first connection member (21) is provided with a first protrusion (211) away from the bracket (3).

3. The battery module collection mechanism (1) of claim 2, **characterized in that** the collection group (100) is provided in two, and virtual extension lines of two first protrusions (211) of the two collection groups (100) coincide with each other.

4. The battery module collection mechanism (1) of claim 2, **characterized in that** the first connection member (21) is provided with two first recesses (212) on both sides of the first protrusion (211).

5. The battery module collection mechanism (1) of claim 2, **characterized in that** the collection group (100) further comprises a collection assembly (120), the collection assembly (120) comprises a first collection line (13) and a second collection line (14) each installed on the bracket (3) and arranged oppositely; and the first collection line (13) is electrically connected to two first serial rows (101) of both the first serial group (11) and the second serial group (12), and the second collection line (14) is electrically connected to two second serial rows (102) of both the first serial group (11) and the second serial group (12).

6. The battery module collection mechanism (1) of claim 5, **characterized in that** the first collection line (13) comprises two first connection portions (131) and a first buffer portion (132) connected between the two first connection portions (131), the two first connection portions (131) are connected to the two first serial rows (101) of both the first serial group (11) and the second serial group (12), respectively, and the first buffer portion (132) is provided with a first groove (133) toward the bracket (3); the second collection line (14) comprises two second connection portions (141) and a second buffer portion (142) connected between the two second connection portions (141), the two second connection portions (141) are connected to the two second serial rows (102) of both the first serial group (11) and the second serial group (12), respectively, and the second buffer portion (142) is provided with a second groove (143) toward the bracket (3); and a virtual connection line between a center of the second groove (143) and a center of the first groove (133) is perpendicular to an extension direction of the first collection line (13).

7. The battery module collection mechanism (1) of claim 6, **characterized in that** extension directions of two first collection lines (13) of the two collection groups (100) are parallel to each other.

8. The battery module collection mechanism (1) of any one of claims 1-6, **characterized in that** the bracket (3) are provided with a plurality of explosion-proof holes (33) respectively disposed between the first serial row (101) and the second serial row (102).

9. The battery module collection mechanism (1) of any one of claims 5-7, **characterized in that** the serial assembly (110) further comprises two connection circuit boards (4) respectively connected to the first collection line (13) and the second connection line (14) and respectively disposed at one ends of the first collection line (13) and the second collection line (14).

10. The battery module collection mechanism (1) of claim 4, **characterized in that** a depth of the first recess (212) is equal to a height of the first protrusion (211).

11. A battery module, **characterized in that** the battery module comprises one or more battery grouping assemblies (7) and the battery module collection mechanism (1) of any one of claims 1-10 provided in a number corresponding to a number of the battery grouping assemblies (7), wherein each of the battery grouping assemblies (7) comprises four cell groups, the battery module collection mechanism (1) comprises two collection groups (100), and each of the collection groups (100) corresponds to two of the cell groups.

12. The battery module of claim 11, **characterized in that** the battery module further comprises an integrated connection assembly comprising a first integrated member (22), wherein two first serial rows (101) of two serial assemblies (110) are interconnected with each other by the first integrated member (22), the first integrated member (22) is configured to connect the two second serial rows (102) of the two collection groups (100) when the first connection member (21) is configured to connect the two first serial row (101) of both the first serial group (11) and the second serial group (12), and the first integrated member (22) is configured to connect the two first serial rows (101) of the two collection groups (100) when the first connection member (21) is configured to connect the two second serial row (102) of both the first serial group (11) and the second serial group (12).

13. The battery module of claim 12, **characterized in that** the cell grouping assemblies (7) are provided in two, the battery module collection mechanism (1) is provided in two corresponding to the two cell grouping assemblies (7), the integrated connection assembly comprises a second integrated member (23) disposed on a side of the first serial row (101) away from the first integrated member (22), the two second serial rows (102) of the two first serial groups (11) of the two battery module collection mechanisms (1) are interconnected with each other by the second integrated member (23) when the first connection member (21) is configured to connect the two first serial rows (101) of both the first serial group (11) and the second serial group (12), and the two first serial rows (101) of the two first serial groups (11) of the two battery module collection mechanisms (1) are interconnected with each other by the second integrated member (23) when the first connection member (21) is configured to connect the two second serial rows (102) of both the first serial group (11) and the second serial group (12).

14. The battery module of claim 12, **characterized in that** the battery module further comprises a positioning member connected to a side of the bracket (3) toward the battery grouping assemblies, wherein the positioning member is positioned between the two first serial rows (101) or the second serial rows (102) of both the first serial group (11) and the second serial group (12), and the positioning member is provided with a positioning groove for embedding a pole of a cell into the positioning groove.

15. The battery module of any one of claims 11-14, **characterized in that** the bracket (3) are provided with a plurality of collection line installing grooves (31) and a plurality of connection member installing grooves (32).

## Patentansprüche

1. Ein Sammelmechanismus (1) für Batteriemodule, **dadurch gekennzeichnet, dass** der Sammelmechanismus (1) Folgendes umfasst:
eine Halterung (3); und
eine Sammelgruppe (100), die eine Reihenschaltung (110) umfasst;
wobei die Reihenschaltung (110) eine erste Reihenschaltungsgruppe (11), eine zweite Reihenschaltungsgruppe (12) und ein erstes Verbindungselement (21) umfasst, die alle an der Halterung (3) angeordnet sind, wobei die erste Reihenschaltungsgruppe (11) und die zweite Reihenschaltungsgruppe (12) jeweils eine erste Reihe (101) und eine zweite Reihe (102), die einander gegenüberliegend angeordnet sind, und die erste Reihenschaltungsgruppe (11) sowie die zweite Reihenschaltungsgruppe (12) jeweils in Reihe mit einer Zellengruppe geschaltet sind, und zwei erste Reihen (101) oder zwei zweite Reihen (102) sowohl der ersten Reihenschaltungsgruppe (11) als auch der zweiten Reihenschaltungsgruppe (12) durch das erste Verbindungselement (21) miteinander verbunden sind.

2. Sammelmechanismus (1) für Batteriemodule gemäß Anspruch 1, **dadurch gekennzeichnet, dass** das erste Verbindungselement (21) mit einem ersten Vorsprung (211) versehen ist, der von der Halterung (3) wegweist.

3. Sammelmechanismus (1) für Batteriemodule gemäß Anspruch 2, **dadurch gekennzeichnet, dass** zwei Sammelgruppen (100) vorgesehen sind und die virtuellen Verlängerungslinien von zwei ersten Vorsprüngen (211) der beiden Sammelgruppen (100) miteinander zusammenfallen.

4. Sammelmechanismus (1) für Batteriemodule gemäß Anspruch 2, **dadurch gekennzeichnet, dass** das erste Verbindungselement (21) beiderseits des ersten Vorsprungs (211) mit zwei ersten Aussparungen (212) versehen ist.

5. Sammelmechanismus (1) für Batteriemodule gemäß Anspruch 2, **dadurch gekennzeichnet, dass** die Sammelgruppe (100) ferner eine Sammelbaugruppe (120) umfasst, wobei die Sammelbaugruppe (120) eine erste Sammelleitung (13) und eine zweite Sammelleitung (14) umfasst, die jeweils an der Halterung (3) angebracht und einander gegenüberliegend angeordnet sind; und die erste Sammelleitung (13) elektrisch mit zwei ersten Reihen (101) sowohl der ersten Reihenschaltungsgruppe (11) als auch der zweiten Reihenschaltungsgruppe (12) verbunden ist, und die zweite Sammelleitung (14) elektrisch mit zwei zweiten Reihen (102) sowohl der ersten Reihenschaltungsgruppe (11) als auch der zweiten Reihenschaltungsgruppe (12) verbunden ist.

6. Sammelmechanismus (1) für Batteriemodule gemäß Anspruch 5, **dadurch gekennzeichnet, dass** die erste Sammelleitung (13) zwei erste Verbindungsabschnitte (131) und einen ersten Pufferabschnitt (132) umfasst, der zwischen den beiden ersten Verbindungsabschnitten (131) angeschlossen ist, die beiden ersten Verbindungsabschnitte (131) jeweils mit den beiden ersten Reihen (101) sowohl der ersten Reihenschaltungsgruppe (11) als auch der zweiten Reihenschaltungsgruppe (12) verbunden sind und der erste Pufferabschnitt (132) mit einer ersten Nut (133) in Richtung der Halterung (3) versehen ist; die zweite Sammelleitung (14) zwei zweite Verbindungsabschnitte (141) und einen zweiten Pufferabschnitt (142) umfasst, der zwischen den beiden zweiten Verbindungsabschnitten (141) angeschlossen ist; die beiden zweiten Verbindungsabschnitte (141) jeweils mit den beiden zweiten Reihen (102) sowohl der ersten Reihenschaltungsgruppe (11) als auch der zweiten Reihenschaltungsgruppe (12) verbunden sind, und der zweite Pufferabschnitt (142) mit einer zweiten Nut (143) in Richtung der Halterung (3) versehen ist; und eine virtuelle Verbindungslinie zwischen einer Mitte der zweiten Nut (143) und einer Mitte der ersten Nut (133) senkrecht zu einer Ausdehnungsrichtung der ersten Sammelleitung (13) verläuft.

7. Sammelmechanismus (1) für Batteriemodule gemäß Anspruch 6, **dadurch gekennzeichnet, dass** die Ausdehnungsrichtungen von zwei ersten Sammelleitungen (13) der beiden Sammelgruppen (100) parallel zueinander verlaufen.

8. Sammelmechanismus (1) für Batteriemodule gemäß einem der Ansprüche 1 bis 6, **dadurch gekennzeichnet, dass** die Halterung (3) mit einer Vielzahl von explosionsgeschützten Löchern (33) versehen ist, die jeweils zwischen der ersten Reihe (101) und der zweiten Reihe (102) angeordnet sind.

9. Sammelmechanismus (1) für Batteriemodule gemäß einem der Ansprüche 5 bis 7, **dadurch gekennzeichnet, dass** die Reihenschaltung (110) ferner zwei Verbindungsleiterplatten (4) umfasst, die jeweils mit der ersten Sammelleitung (13) und der zweiten Sammelleitung (14) verbunden sind und jeweils an einem Ende der ersten Sammelleitung (13) bzw. der zweiten Sammelleitung (14) angeordnet sind.

10. Sammelmechanismus (1) für Batteriemodule gemäß Anspruch 4, **dadurch gekennzeichnet, dass** die Tiefe der ersten Aussparung (212) der Höhe des ersten Vorsprungs (211) entspricht.

11. Batteriemodul, **dadurch gekennzeichnet, dass** das Batteriemodul eine oder mehrere Batteriegruppierungsbaugruppen (7) und den in einem der Ansprüche 1 bis 10 genannten Sammelmechanismus (1) in einer Anzahl umfasst, die der Anzahl der Batteriegruppierungsbaugruppen (7) entspricht, wobei jede der Batteriegruppierungsbaugruppen (7) vier Zellengruppen umfasst, der Sammelmechanismus (1) zwei Sammelgruppen (100) umfasst und jede der Sammelgruppen (100) zwei der Zellengruppen entspricht.

12. Das Batteriemodul gemäß Anspruch 11, **dadurch gekennzeichnet, dass** das Batteriemodul ferner eine integrierte Verbindungsbaugruppe umfasst, die ein erstes integriertes Element (22) umfasst, wobei zwei erste Reihen (101) von zwei Reihenschaltungen (110) durch das erste integrierte Element (22) miteinander verbunden sind, das erste integrierte Element (22) so ausgelegt ist, dass es die beiden zweiten Reihen (102) der beiden Sammelgruppen (100) verbindet, wenn das erste Verbindungselement (21) so ausgelegt ist, dass es die beiden ersten Reihen (101) sowohl der ersten Reihenschaltungsgruppe (11) als auch der zweiten Reihenschaltungsgruppe (12) verbindet, und das erste integrierte Element (22) ist so ausgelegt, dass es die beiden ersten Reihen (101) der beiden Sammelgruppen (100) verbindet, wenn das erste Verbindungselement (21) so ausgelegt ist, dass es die beiden zweiten Reihen (102) sowohl der ersten Reihenschaltungsgruppe (11) als auch der zweiten Reihenschaltungsgruppe (12) verbindet.

13. Batteriemodul gemäß Anspruch 12, **dadurch gekennzeichnet, dass** zwei Batteriegruppierungsbaugruppen (7) vorgesehen sind, dass der Sammelmechanismus (1) entsprechend den beiden Batteriegruppierungsbaugruppen (7) in zwei Ausführungen vorgesehen ist, dass die integrierte Verbindungsbaugruppe ein zweites integriertes Element (23) umfasst, das auf einer Seite der ersten Reihe (101) angeordnet ist, die vom ersten integrierten Element (22) abgewandt ist, die beiden zweiten Reihen (102) der beiden ersten Reihenschaltungsgruppen (11) der beiden Sammelmechanismen (1) durch das zweite integrierte Element (23) miteinander verbunden sind, wenn das erste Verbindungselement (21) so konfiguriert ist, dass es die beiden ersten Reihen (101) sowohl der ersten Reihenschaltungsgruppe (11) als auch der zweiten Reihenschaltungsgruppe (12) verbindet, und die beiden ersten Reihen (101) der beiden ersten Reihenschaltungsgruppen (11) der beiden Sammelmechanismen (1) sind durch das zweite integrierte Element (23) miteinander verbunden, wenn das erste Verbindungselement (21) so konfiguriert ist, dass es die beiden zweiten Reihen (102) sowohl der ersten Reihenschaltungsgruppe (11) als auch der zweiten Reihenschaltungsgruppe (12) verbindet.

14. Batteriemodul gemäß Anspruch 12, **dadurch gekennzeichnet, dass** das Batteriemodul ferner ein Positionierungselement umfasst, das mit einer den Batteriegruppierungsbaugruppen zugewandten Seite der Halterung (3) verbunden ist, wobei das Positionierungselement zwischen den beiden ersten Reihen (101) oder den zweiten Reihen (102) sowohl der ersten Reihenschaltungsgruppe (11) als auch der zweiten Reihenschaltungsgruppe (12) angeordnet ist, und das Positionierungselement mit einer Positionierungsnut zum Einlegen eines Pols einer Zellengruppe in die Positionierungsnut versehen ist.

15. Batteriemodul gemäß einem der Ansprüche 11 bis 14, **dadurch gekennzeichnet, dass** die Halterung (3) mit mehreren Einbaunuten (31) für Sammelleitungen und mehreren Einbaunuten (32) für Verbindungselemente versehen ist.

## Revendications

1. Un mécanisme de collecte (1) des modules de batterie, **caractérisé en ce que** ledit mécanisme de collecte (1) comprend :
un support (3) ; et
un groupe de collecte (100) comprenant un ensemble en série (110) ;
dans lequel l'ensemble en série (110) comprend un premier groupe en série (11), un deuxième groupe en série (12) et un premier élément de connexion (21), tous disposés sur le support (3) ; le premier groupe en série (11) et le deuxième groupe en série (12) comprennent chacun une première rangée en série (101) et une deuxième rangée en série (102) disposées en vis-à-vis, et le premier groupe en série (11) et le deuxième groupe en série (12) sont chacun connectés en série à un groupe de cellules, et deux premières rangées en série (101) ou deux deuxièmes rangées en série (102) du premier groupe en série (11) et du deuxième groupe en série (12) sont reliées entre elles par le premier élément de connexion (21).

2. Le mécanisme de collecte (1) des modules de batterie selon la revendication 1, **caractérisé en ce que** le premier élément de connexion (21) est muni d'une première saillie (211) située à l'opposé du support (3).

3. Le mécanisme de collecte (1) des modules de batterie selon la revendication 2, **caractérisé en ce que** le groupe de collecte (100) est présent en deux exemplaires, et **en ce que** les prolongements virtuels de deux premières saillies (211) des deux groupes de collecte (100) coïncident l'un avec l'autre.

4. Le mécanisme de collecte (1) des modules de batterie selon la revendication 2, **caractérisé en ce que** le premier élément de connexion (21) est muni de deux premiers évidements (212) situés de part et d'autre de la première saillie (211).

5. Le mécanisme de collecte (1) des modules de batterie selon la revendication 2, **caractérisé en ce que** le groupe de collecte (100) comprend en outre un ensemble de collecte (120), ledit ensemble de collecte (120) comprenant une première ligne de collecte (13) et une deuxième ligne de collecte (14), chacune étant installée sur le support (3) et disposée de manière opposée ; et la première ligne de collecte (13) est reliée électriquement à deux premières rangées en série (101) du premier groupe en série (11) et du deuxième groupe en série (12), et la deuxième ligne de collecte (14) est reliée électriquement à deux deuxièmes rangées en série (102) du premier groupe en série (11) et du deuxième groupe en série (12).

6. Le mécanisme de collecte (1) des modules de batterie selon la revendication 5, **caractérisé en ce que** la première ligne de collecte (13) comprend deux premières parties de connexion (131) et une première partie tampon (132) reliée entre les deux premières parties de connexion (131), les deux premières parties de connexion (131) sont reliées respectivement aux deux premières rangées en série (101) du premier groupe en série (11) et du deuxième groupe en série (12), et la première partie tampon (132) est fournie d'une première rainure (133) orientée vers le support (3) ; la deuxième ligne de collecte (14) comprend deux deuxièmes parties de connexion (141) et une deuxième partie tampon (142) reliée entre les deux deuxièmes parties de connexion (141), les deux deuxièmes parties de connexion (141) sont reliées aux deux deuxièmes rangées en série (102) du premier groupe en série (11) et du deuxième groupe en série (12), respectivement, et la deuxième partie tampon (142) est fournie d'une deuxième rainure (143) orientée vers le support (3) ; et une ligne de connexion virtuelle entre le centre de la deuxième rainure (143) et le centre de la première rainure (133) est perpendiculaire à la direction d'extension de la première ligne de collecte (13).

7. Le mécanisme de collecte (1) pour modules de batterie selon la revendication 6, **caractérisé en ce que** les directions d'extension de deux premières lignes de collecte (13) des deux groupes de collecte (100) sont parallèles entre elles.

8. Le mécanisme de collecte (1) des modules de batterie selon l'une quelconque des revendications 1 à 6, **caractérisé en ce que** le support (3) est fourni d'une pluralité de trous antidéflagrants (33) disposés respectivement entre la première rangée en série (101) et la deuxième rangée en série (102).

9. Le mécanisme de collecte (1) des modules de batterie selon l'une quelconque des revendications 5 à 7, **caractérisé en ce que** l'ensemble en série (110) comprend en outre deux cartes de circuit imprimé de connexion (4) respectivement reliées à la première ligne de collecte (13) et à la deuxième ligne de collecte (14), et disposées respectivement à une extrémité de la première ligne de collecte (13) et à une extrémité de la deuxième ligne de collecte (14).

10. Le mécanisme de collecte (1) des modules de batterie selon la revendication 4, **caractérisé en ce que** la profondeur du premier évidement (212) est égale à la hauteur de la première saillie (211).

11. Un module de batterie, **caractérisé en ce qu'**il comprend un ou plusieurs ensembles de regroupement de batteries (7) et le mécanisme de collecte (1) selon l'une quelconque des revendications 1 à 10, fourni en un nombre correspondant au nombre d'ensembles de regroupement de batteries (7), dans lequel chacun des ensembles de regroupement de batteries (7) comprend quatre groupes de cellules, le mécanisme de collecte (1) comprend deux groupes de collecte (100), et chacun des groupes de collecte (100) correspond à deux des groupes de cellules.

12. Le module de batterie selon la revendication 11, **caractérisé en ce que** le module de batterie comprend en outre un ensemble de connexion intégré comprenant un premier élément intégré (22), dans lequel deux premières rangées en série (101) de deux ensembles en série (110) sont interconnectées l'une à l'autre par le premier élément intégré (22), le premier élément intégré (22) est configuré pour relier les deux deuxièmes rangées en série (102) des deux groupes de collecte (100) lorsque le premier élément de connexion (21) est configuré pour relier les deux premières rangées en série (101) à la fois du premier groupe en série (11) et du deuxième groupe en série (12), et le premier élément intégré (22) est configuré pour relier les deux premières rangées en série (101) des deux groupes de collecte (100) lorsque le premier élément de connexion (21) est configuré pour relier les deux deuxièmes rangées en série (102) à la fois du premier groupe en série (11) et du deuxième groupe en série (12).

13. Le module de batterie selon la revendication 12, **caractérisé en ce que** les ensembles de regroupement de batteries (7) sont au nombre de deux, le mécanisme de collecte (1) est au nombre de deux, correspondant aux deux ensembles de regroupement de batteries (7), l'ensemble de connexion intégré comprend un deuxième élément intégré (23) disposé sur un côté de la première rangée en série (101) opposé au premier élément intégré (22), les deux deuxièmes rangées en série (102) des deux premiers groupes en série (11) des deux mécanismes de collecte (1) sont interconnectées entre elles par le deuxième élément intégré (23) lorsque le premier élément de connexion (21) est configuré pour connecter les deux premières rangées en série (101) à la fois du premier groupe en série (11) et du deuxième groupe en série (12), et les deux premières rangées en série (101) des deux premiers groupes en série (11) des deux mécanismes de collecte (1) sont interconnectées entre elles par le deuxième élément intégré (23) lorsque le premier élément de connexion (21) est configuré pour connecter les deux deuxièmes rangées en série (102) à la fois du premier groupe en série (11) et du deuxième groupe en série (12).

14. Le module de batterie selon la revendication 12, **caractérisé en ce que** le module de batterie comprend en outre un élément de positionnement relié à un côté du support (3) tourné vers les ensembles de regroupement de batteries, l'élément de positionnement étant positionné entre les deux premières rangées en série (101) ou les deuxièmes rangées en série (102) du premier groupe en série (11) et du deuxième groupe en série (12), et l'élément de positionnement est muni d'une rainure de positionnement destinée à recevoir un pôle d'une cellule dans ladite rainure de positionnement.

15. Le module de batterie selon l'une quelconque des revendications 11 à 14, **caractérisé en ce que** le support (3) est muni d'une pluralité de rainures de réception (31) pour lignes de collecte et d'une pluralité de rainures de réception (32) pour éléments de connexion.
